# EUROPEAN PATENT APPLICATION

(11) **EP 2 677 540 A1**
(43) Date of publication of application: **25.12.2013**
(21) Application number: 12172505.5
(22) Date of filing: 19.06.2012
(51) Int. Cl.: H01L 23/485, H01L 23/488, H01L 23/62

(54) **Electronic device and method of manufacturing the same**

(71) Applicant: NXP B.V., 5656 AG Eindhoven (NL)
(72) Inventor: Tijssen, Edwin, 5656 AG EIndhoven (NL); Walczyk, Sven, 5656 AG Eindhoven (NL); Groenhuis, Roelf, 5656 AG Eindhoven (NL); Weber, Rüdiger, 5656 AG Eindhoven (NL); Tee, CheeWee, 5656 AG Eindhoven (NL)
(74) Representative: Krott, Michel

(57) **Abstract**

The invention relates to an electronic device (200) for protection against transient voltages in high-power applications. The electronic device (200) comprises: i) a semiconductor substrate (220) comprising an active element (Dd) having at least two terminals (T1, T2); ii) a conductive pad (225) provided on said substrate (220) and being electrically coupled to one of said terminals (T1, T2); iii) electrically-conductive solder material (226) provided on the conductive pad (225); iv) a first conductive part (230) electrically coupled to the conductive pad (225) via the electrically-conductive interconnect material (226). The electronic device further comprises a wall (229) being provided along the periphery of the conductive pad (225) for forming a lateral confinement of the interconnect material (226) on the conductive pad (225). The invention further relates to a method of manufacturing such electronic device. The proposed invention offers a solution for two problems: a) limited interconnect coverage when using lead-solder (due to the solder limitation), and b) the limitations when using lead-free materials (due to the government restrictions).

## Description

### FIELD OF THE INVENTION

The invention relates to an electronic device for protection against transient-voltages in high-power applications.

The invention further relates to a method of manufacturing such device.

### BACKGROUND OF THE INVENTION

A lot of research has been done on Transient Voltage Suppression (TVS) circuits, in particular using TVS diodes for providing a simple solution to increase the immunity level against electrical overstress of an electronic circuit from transients caused e.g. by lightning, inductive load switching and electrostatic discharge (ESD). Such TVS diodes are typically used in TVS protection circuits of which many variations have been reported in the prior art. What all such circuits have at least in common is that they all make use of rectifying elements of which the diode is widely used. An alternative rectifying element is a transistor having its gate shortcircuited to the source or drain.

The functional performance of a TVS diode is significantly influenced by the package. More precisely, the maximum peak pulse power (PPP) depends on the amount of transient heat that can be dissipated from the junction area of the diode to the outer part of the package. Heat dissipation is optimized when the backside and, in particular, the topside of the die (substrate comprising the diode) are fully soldered to a copper part (a clip or lead frame).

The maximum size of the soldered area (the bond pad) is limited to prevent electrical shortage due to small solder remains that are always formed during reflow.

Besides this, the EU-government restricts the use of lead-solder widely used for such kind of devices. Exemptions will be revised in 2014. At present, all lead-free materials that could replace lead solder do not selectively wet to the bond pad of the die (one of the connection terminals of the diode). This is because these materials lack the material property of selectively wetting, i.e. it is not possible to maximize coverage to the bond pad without risking electrical shortages.

The above-mentioned problems are particularly relevant for the high-power applications, such as in communications (example: charger line protection from inductive coupling surges), industrial applications (example: DC motor EMI limiting), and automotive applications (example: fuel-injector transient limiting). In the applications here mentioned the respective diodes need to be able to dissipate up to and even over 600W in a so called 10/1000µs surge pulse.

### SUMMARY OF THE INVENTION

The proposed invention offers a solution for both the earlier-described limited solder coverage when using lead-solder (due to the solder limitation), and for the limitations when using lead-free materials (due to the government restrictions). The invention is defined by the independent claims. The dependent claims define advantageous embodiments.

In accordance with a first aspect of the invention an electronic device for protection against transient voltages in high-power applications as described in claim 1 is provided. The electronic device comprises:
- a semiconductor substrate comprising an active element having at least two terminals;
- a conductive pad provided on said substrate and being electrically coupled to one of said terminals;
- electrically-conductive interconnect material provided on the conductive pad, and
- a first conductive part electrically coupled to the conductive pad via the electrically-conductive interconnect material.

The electronic device in accordance with the invention further comprises a wall being provided along the periphery of the conductive pad for forming a lateral confinement of the interconnect material on the conductive pad.

The electronic device constitutes a significant improvement over the prior art devices. The provision of a wall along the periphery of the conductive pad for forming a lateral confinement of the interconnect material has two effects. The first effect (for lead solder) is that it prevents lead solder material to get outside the conductive pad (bond pad) during reflow, because it forms a confinement for this solder material. So, expressed differently, it becomes easier to increase the ratio of bond pad size over silicon die size, and thus to increase the product PPP performance without the need to increase the die size or package size. The second effect (for leadfree interconnect materials) is that the wall makes it easier to apply lead-free interconnect materials such that the bond-pad is completely covered even if the lead-free interconnect material does not selectively wet to the bond-pad.

In order to facilitate the understanding of the invention a few expressions are defined hereinafter.

Throughout the description the term "high-power" implies power levels in a 10/1000µs surge pulse of the order of hundreds or even thousands of watts, i.e. 600 W or even 1500 Watt or more. However, it must be stressed that, albeit that the invention is particularly advantageous in high-power applications, the invention is also advantageous in lower power applications, i.e. the prevention of short-circuits on the die, and the better wettability in case of lead-free interconnect materials.

Throughout the description the term "substrate" is defined as a carrier onto which or in which an active element (such as a diode and a transistor) is integrated. Such substrate may be a semiconductor substrate, but this is not essential (for example, a silicon-on-insulator substrate or a silicon-on-anything substrate).

Throughout the description the term "active element" is defined as an element of an electronic circuit, such as a transistor, a diode, a thyristor, etc. All such elements may be used as rectifying elements in transient voltage suppression circuits.

Throughout the description the term "terminal" is defined as an electrical connection of an active element, such as a gate connection, a drain connection, a source connection, and a bulk connection.

Throughout the description the term "interconnect material" is defined as a conductive material that is suitable for soldering parts together such that a physical, but also an electrical connection is achieved.

In an embodiment of the electronic device the wall comprises organic material. Organic materials are materials that are readily available in most manufacturing environments (cleanrooms, etc.). Moreover, such materials are generally quite easy to deposit and pattern using conventional techniques.

In an embodiment of the electronic device the wall comprises material selected from a group comprising: polyimide, and epoxy polymer. These materials are examples of organic materials.

In an embodiment of the electronic device the active element comprises at least one of a diode, a transistor, and a thyristor. These three are the most common examples of active elements that are used as rectifier elements in transient voltage suppressor circuits.

In an embodiment of the electronic device the electrically-conductive interconnect material comprises material selected from a group comprising: lead solder and lead-free interconnect materials such as high-conductive adhesives and sinter silver. As already explained earlier, the invention is applicable to both kinds of interconnect material and solves respective problems that exist for the respective types.

An embodiment of the electronic device further comprises a second conductive part electrically coupled to another one of said at least two terminals. An active element, such as a diode, has mostly at least two terminals. Therefore, this embodiment conveniently renders external connection of such active element possible. In a further embodiment, wherein a transistor (having three terminals) is used as active element, the electronic device further comprises a third conductive part electrically coupled to the respective third terminal of the transistor. In yet another embodiment, wherein a thyristor (having four terminals) is used as active element, the electronic device further comprises a fourth conductive part electrically coupled to the respective fourth terminal of the transistor.

In accordance with a second aspect, the invention provides a packaged semiconductor component comprising the electronic device of the invention. Packaging a semiconductor component, such as a diode, conventionally means that the silicon substrate is connected to copper parts, and embedded in an epoxy or resin material.

In accordance with a third aspect, the invention provides a transient-voltage suppression circuit comprising the electronic device of the invention. TVS circuits typically benefit from the electronic device of the invention. However, the invention is not limited to such applications only.

In accordance with a fourth aspect, the invention provides a method of manufacturing an electronic device for protection against transient voltages in high-power applications. The method of the invention comprises:
- providing an intermediate device comprising:
   i) a semiconductor substrate comprising an active element having at least two terminals, and
   ii) a conductive pad provided on said substrate and being electrically coupled to one of said terminals;
- providing a wall along the periphery of the conductive pad for forming a lateral confinement of interconnect material to be applied on the conductive pad, and
- providing electrically-conductive interconnect material on the conductive pad. The advantages and effects of the method of the invention follow those of the corresponding embodiments of the electronic device of the invention.

An embodiment of the method further comprises: providing a first conductive part and electrically coupling said part to the conductive pad via the electrically-conductive interconnect material.

An embodiment of the method further comprises: providing a second conductive part and electrically coupling said part to another one of said at least two terminals.

An embodiment of the method further comprises packaging said electronic device to obtain a packaged semiconductor component.

In an embodiment of the method the wall that is provided comprises organic material.

In an embodiment of the method the wall that is provided comprises material selected from a group comprising: polyimide, and epoxy polymer.

### BRIEF DESCRIPTION OF THE DRAWINGS

These and other aspects of the invention are apparent from and will be elucidated with reference to the embodiments described hereinafter. In the drawings,
Fig. 1 shows two different internal protection circuits comprising TVS diodes;
Fig. 2 shows a schematic view of a semiconductor component comprising a TVS diode;
Fig. 3 shows a cross-section of a semiconductor component as illustrated in Fig. 2;
Fig. 4 shows a photograph of a TVS diode after a failure;
Fig. 5 shows a schematic overview of an electronic device in accordance with an embodiment the invention;
Fig. 6 shows a photograph of a cross-section of the electronic device as illustrated in Fig. 5 after the provision of a conductive part and interconnect material;
Fig. 7 shows a photograph of a wafer comprising a plurality of electronic devices in accordance with the invention;
Fig. 8 shows a zoom-view of the photograph of Fig. 7;
Fig. 9 shows a schematic view of an electronic device in accordance with another embodiment of the invention, wherein the wall has been left out, wherein a diode is implemented underneath a bond pad, and
Fig. 10 shows a detailed schematic zoom-view of a cross-section of the electronic device as illustrated in Fig. 9.

It should be noted that items which have the same reference numbers in different Figures, have the same structural features and the same functions, or are the same signals. Where the function and/or structure of such an item has been explained, there is no necessity for repeated explanation thereof in the detailed description.

### List of Reference Numerals:

- 50, 50': examples of transient voltage suppression circuits
- 100: TVS diode (example of electronic device of the invention)
- 200: receiver
- 300: transmitter
- 400: logic circuit
- Vdd: first power supply terminal
- Vss: second power supply terminal
- Gnd: ground terminal
- D_High: high I/O pin of receiver (to be protected against transient voltages)
- D_Low: low I/O pin of receiver (to be protected against transient voltages)
- I/O: I/O pin of logic circuit (to be protected against transient voltages)
- 110: second conductive part (lead frame),
- 120: substrate/die (comprising active element)
- 130: first conductive part (lead frame)
- 140: Epoxy or resin
- 125: unsoldered part of the bond pad
- 126: soldered part of the bond pad
- 999: location of breakdown failure
- 200: electronic device according to the invention
- 220: substrate of electronic device according to the invention
- 225: bond pad of electronic device according to the invention
- 228: insulating layer around periphery bond pad
- 229: (organic) wall of electronic device according to the invention
- 230: first conductive part of electronic device according to the invention (clip).
- 226: interconnect material (such as lead solder)
- 222: scribe line of wafer
- 77: periphery (GOV edge) of bond pad defined by GOV mask
- 88: periphery (INSO edge) of bond pad defined by INSO mask
- 220-1: n-type substrate (doped with antimony)
- 220-2: n-type epitaxial layer (doped with phosphorous)
- 220-3: n-well (defined by DN mask, doped with phosphorous)
- 220-4: p-well (defined by SP mask, doped with Boron)
- 220-5: first thermally-grown oxide (defined by SP mask)
- 220-6: second thermally-grown oxide (defined by CO mask)
- 220-7: first conductive layer (defined by IN mask)
- 220-8: glass-over (GOV, silicon nitride) layer
- 220-9: second conductive layer
- Dd: active element (diode)
- T1: first terminal of diode
- T2: second terminal of diode

### DETAILED EMBODIMENTS

While this invention is susceptible of embodiment in many different forms, there is shown in the drawings and will herein be described in detail one or more specific embodiments, with the understanding that the present disclosure is to be considered as exemplary of the principles of the invention and not intended to limit the invention to the specific embodiments shown and described.

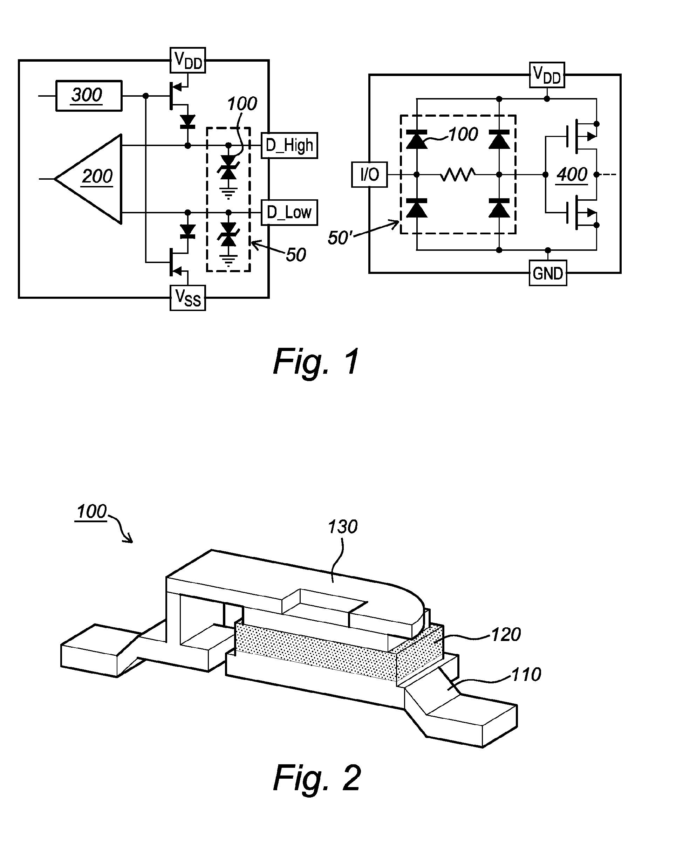

**Fig. 1** shows two different internal protection circuits comprising TVS diodes. Both protection circuit examples are integrated on-chip. However, off-chip protection circuits exist as well and the principles are the same. The invention is applicable to both off-chip and on-chip solutions. On the left-side in **Fig. 1** there is shown a transceiver IC that requires power surge and ESD protection. The transceiver IC has four pins, namely a first power supply terminal Vdd, a second power supply terminal Vss, and two I/O pins, D-High, D_Low. The transceiver IC comprises a receiver 200 being coupled to the two respective I/O pins D_High, D_Low that need protection. A transient voltage protection circuit 50 is provided to protect said input/outputs D_High, D_Low. The transceiver IC further comprises a transmitter 300 that is also coupled to said I/O pins D_High, D_Low. The transient voltage protection circuit 50 in this example comprises TVS diodes 100 (in this example Zener diodes).

On the right-side in **Fig. 1** there is shown a logic IC that requires power and ESD protection. The logic IC comprises a logic circuit 400 that is coupled with the first power supply terminal Vdd and a ground terminal Gnd. The logic IC comprises an alternative transient voltage protection circuit 50' that comprises an array of diodes 100. The array of diode 100 protects the I/O pin of said logic circuit 400.

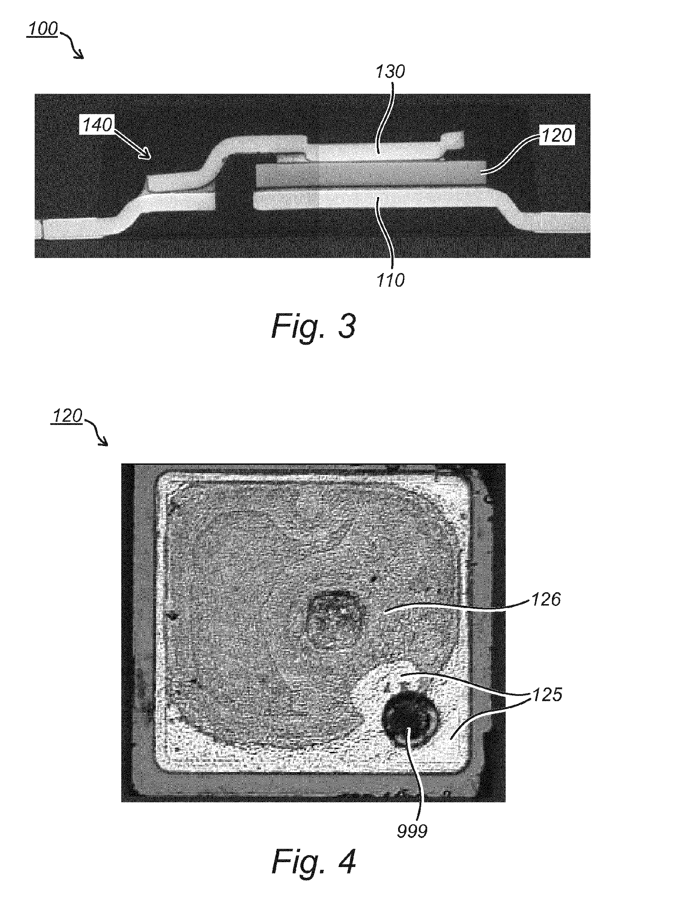

**Fig. 2** shows a schematic view of a semiconductor component comprising a TVS diode. **Fig. 3** shows a cross-section of a semiconductor component as illustrated in **Fig. 2****.** TVS diodes are designed to respond quickly to over-voltages. This makes TVS devices useful for protection against damaging voltage spikes. High power TVS diodes (with typically 200-1500W 10/1000µs surge power capability) are conventionally supplied in a so-called clip-bonded package (SOD128 or SOD123W or SMA, SMB, SMC). **Fig. 2** shows an example of an SOD128 package. Such package comprises a substrate/die 120 (comprising the active element, here a TVS diode), a lead frame 110 coupled to a bottom-side of the substrate/die 120, and a clip 130 coupled to a top-side of the substrate/die 120. The clip 130 generally comprises copper and forms the first conductive part as referred to in the claims. The lead frame 110 generally comprises copper and forms the second conductive part as referred to in the claims. In **Fig. 3** there is also visible an encapsulation around the above-mentioned components, which may generally comprise a resin or epoxy.

So, in a SOD128 package silicon die 120 is clamped between two copper parts 110, 130, and the generated transient heat in the die 120 is distributed over both copper parts 110, 130 (so energy is withdrawn from the die). The level of energy in transient over-voltage can be expressed by peak pulse power (PPP). The PPP value depends on the ability to dissipate energy from the diode surface in a very short time (milliseconds to microseconds). When insufficient energy is withdrawn from the die surface, breakdown will occur on the top of the die 120, and the product is destroyed. **Fig. 4** shows a photograph of a TVS diode after a failure. The photograph shows a topside of a lead-soldered TVS diode. A first soldered part 126 of the bondpad can be distinguished from a second unsoldered part 125. The location of the breakdown failure 999 is exactly inside the unsoldered region 125, because within such unsoldered region 125 the heat is not properly withdrawn from the surface of the die due to the lack of solder material. The maximum PPP level can be increased by increasing the bond pad area (thus allowing more solder near the heat generating topside of the die). This is currently restricted due to the risk of electrical short-circuits (presence of small remains of solder outside the bond pad), not only for lead-free interconnect materials, but also for lead-solder.

Lead-free interconnect materials for replacing lead-solder are being developed worldwide. Application of these new materials into TVS diodes has also been looked at by the inventors. Solder has one unique property: during reflow it becomes liquid. In this liquid phase, it selectively wets the bond pad material. Physically this means that the adhesion between the liquid solder material and the bond pad material is strong. Material outside the bond pad retracts to the bond pad during reflow, provided that no excessive amount of solder is applied. Only small amounts of solder may remain on the area outside the bond pad.

All lead-free materials that have currently been found do not selectively wet the bond pad. This makes it in the prior art impossible to implement lead-free materials into TVS products without significant loss in surge power dissipation capability. Thus the challenges of the prior art may be summarized as follows. In today's leaded solutions, in order to increase the PPP level, a larger part of the top side of the die should be connected by solder. This would allow for more heat dissipation. However, electrical shorts with the sides of the die are not allowed. This limits the extension of the bond pad. In the future's lead-free solutions, there is an additional problem, namely that the lead-free materials do not selectively wet to the bond pad. To prevent possible electrical shorts, less material is deposited on the bond pad. This results in insufficient coverage of the bond pad on the topside of the die, and thus in a low PPP level.

The invention, however, has opened up the possibility to use lead-free materials, without the risk of short-circuiting.

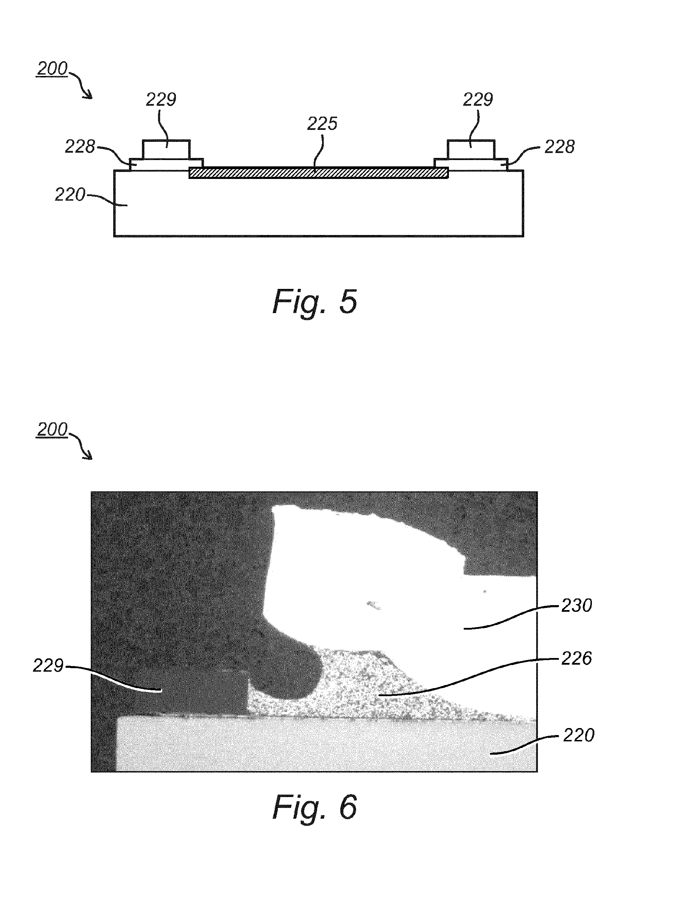

**Fig. 5** shows a schematic overview of an electronic device 200 in accordance with an embodiment the invention. The electronic device 200 comprises a substrate 220, which comprises an active element (now shown). On the top-side of the substrate 220 there is provided a bond pad 225 (conductive pad). Around the periphery of the bond pad 225 there is provided an insulating layer 228 (such as silicon nitride). On top of the insulating layer 228 there is provided a wall 229. Such wall may comprise organic material as such material is generally readily available in semiconductor manufacturing facilities (cleanrooms, etc.). Examples of such material is photoresist, polyimide polymer (PI), and epoxy polymer (SU8). Typical dimensions of the wall are a height of 20-50µm and a width of 20-120µm. The wall of the invention also reduces spill-over of lead-solder which allows a larger bond pad on the same die increasing the PPP level. Effectively, the result is an optimized ratio of interconnect material coverage and die size.

**Fig. 6** shows a photograph of a cross-section of the electronic device as illustrated in Fig. 5 after the provision of a conductive part and interconnect material. This figure will be discussed in as far as different from **Fig. 5****.** The figure shows the organic wall 229 and the interconnect material 226 which is pressed against it by the clip 230. The interesting part of this figure is that the interconnect material is lead-free.

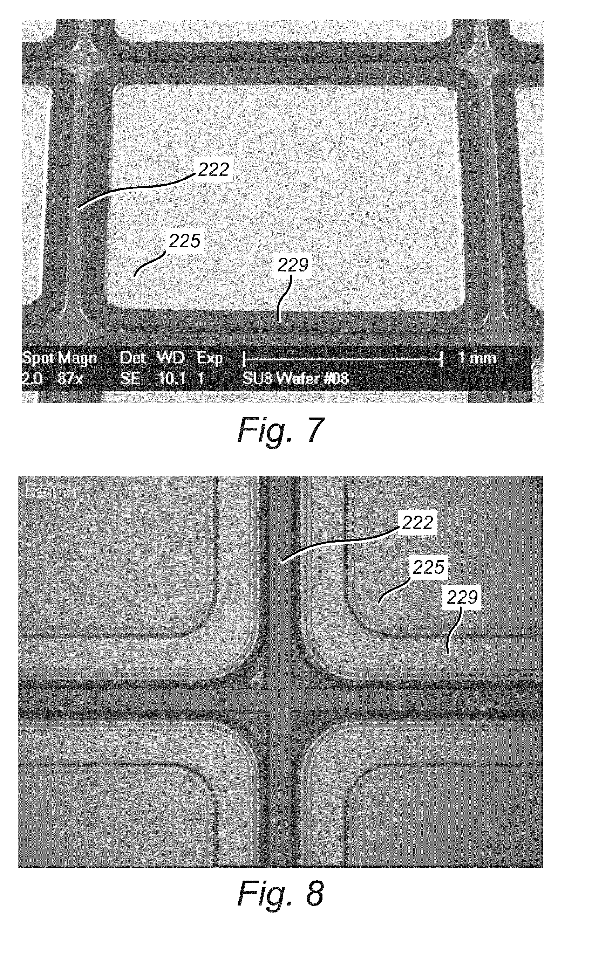

**Fig. 7** shows a photograph of a wafer comprising a plurality of electronic devices in accordance with the invention. **Fig. 8** shows a zoom-view of the photograph of **Fig. 7****.** In the figure only the bond pads 225 are visible, as the diodes are located within the wafer. The bond pads 225 are separated from each other by means of scribe lines 222. Furthermore, the respective walls 229 are visible around the periphery of the respective bond pads 225.

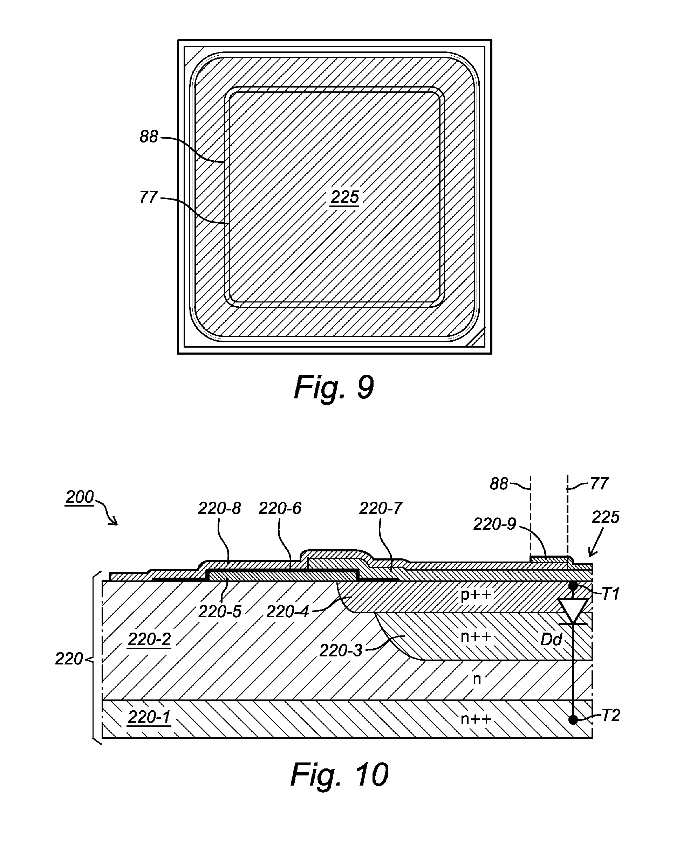

**Fig. 9** shows a schematic view of an electronic device 200 in accordance with another embodiment of the invention, wherein a diode Dd is implemented underneath a bond pad 225. **Fig. 10** shows a detailed schematic zoom-view of a cross-section of the electronic device 200 as illustrated in **Fig. 9****.** In both figures the wall has been left out to simplify the drawing. The top-view in **Fig. 9** shows that the bond pad 225. The electronic device 200 comprises an n-type substrate 220-1 which is doped with antimony in this example. On top of the substrate 220-1 there is an n-type epitaxial (EPI) layer 220-2 which is doped with phosphorous. Within the EPI-layer 220-2 there is provided a deep n-well 220-3 which is doped with phosphorous and defined by a so-called deep-nwell (DN) mask. Also within the EPI-layer 220-3 there is provided a shallow p-well 220-4 which is doped with Boron and defined by a so-called shallow-pwell (SP) mask. Furthermore, there is provided on the surface of the substrate 220 a first thermally-grown oxide 220-5 that is also defined by the SP mask, and a second thermally-grown oxide 220-6 that is defined by a so-called contact (CO) mask. However, such second oxide layer 220-6 is not essential. **Fig. 10** further shows a first conductive layer 220-7 comprising TiAl and being defined by the so-called interconnect (IN) mask. Along the periphery of the first conductive layer 220-7 there is provided a glass-over (GOV) layer 220-8 which may comprise silicon nitride, and on top of the first conductive layer 220-7 there is further provided a second conductive layer, which may comprise TiNi. The active element that is formed in the substrate 220 constitutes a diode Dd being defined by the P-well 220-4/N-well 220-3 junction. The diode Dd has two terminals, one terminal T1 being connected to the bond pad 225 and another one being connected to the back-side of the substrate 220. The periphery of the bond pad 225 shows two edges 77, 88 which are defined by two different masks. A first edge 88 is defined by the GOV mask and defines the effective bond pad area. A second edge 88 defines the overlap of the second conductive layer 220-9 over the glass-over layer 220-8 and is defined by the so-called interconnect solder (INSO) mask. The wall of the invention is not drawn in Fig. 10. However, in the invention the wall may be provided on the glass-over layer 220-8.

Many different ways of executing the methods are possible, as will be apparent to a person skilled in the art. For example, the order of the steps can be varied or some steps may be executed in parallel. Moreover, in between steps other method steps may be inserted. The inserted steps may represent refinements of the method such as described herein, or may be unrelated to the method. Moreover, a given step may not have finished completely before a next step is started.

It should be noted that the above-mentioned embodiments illustrate rather than limit the invention, and that those skilled in the art will be able to design many alternative embodiments.

In the claims, any reference signs placed between parentheses shall not be construed as limiting the claim. Use of the verb "comprise" and its conjugations does not exclude the presence of elements or steps other than those stated in a claim. The article "a" or "an" preceding an element does not exclude the presence of a plurality of such elements. The invention may be implemented by means of hardware comprising several distinct elements, and by means of a suitably programmed computer. In the device claim enumerating several means, several of these means may be embodied by one and the same item of hardware. The mere fact that certain measures are recited in mutually different dependent claims does not indicate that a combination of these measures cannot be used to advantage.

## Claims

1. An electronic device (200) for protection against transient voltages in high-power applications, the electronic device (200) comprising:
- a semiconductor substrate (220) comprising an active element (Dd) having at least two terminals (T1, T2);
- a conductive pad (225) provided on said substrate (220) and being electrically coupled to one of said terminals (T1, T2);
- electrically-conductive interconnect material (226) provided on the conductive pad (225);
- a first conductive part (230) electrically coupled to the conductive pad (225) via the electrically-conductive interconnect material (226),
the electronic device further comprising:
a wall (229) being provided along the periphery of the conductive pad (225) for forming a lateral confinement of the interconnect material (226) on the conductive pad (225).

2. The electronic device (200) as claimed in claim 1, wherein the wall (229) comprises organic material.

3. The electronic device (200) as claimed in claim 2, wherein the wall (229) comprises material selected from a group comprising: polyimide, and epoxy polymer.

4. The electronic device (200) as claimed in any one of the preceding claims, wherein the active element comprises at least one of a diode (Dd), a transistor, and a thyristor.

5. The electronic device (200) as claimed in any one of the preceding claims, wherein the electrically-conductive interconnect material (226) comprises material selected from a group comprising: lead solder and lead-free interconnect materials such as high-conductive adhesives and sinter silver.

6. The electronic device (200) as claimed in any one of the preceding claims, further comprising a second conductive part electrically coupled to another one of said at least two terminals (T1, T2).

7. A packaged semiconductor component comprising the electronic device (200) as claimed in any one of the preceding claims.

8. A transient voltage suppression circuit comprising the electronic device (200 as claimed in any one of claims 1 to 6.

9. A method of manufacturing an electronic device (200) for protection against transient voltages in high-power applications, the method comprising:
- providing an intermediate device comprising:
i) a semiconductor substrate (220) comprising an active element (Dd) having at least two terminals (T1, T2), and
ii) a conductive pad (225) provided on said substrate (220) and being electrically coupled to one of said terminals (T1, T2);
- providing a wall (229) along the periphery of the conductive pad (225) for forming a lateral confinement of interconnect material (226) to be applied on the conductive pad (225), and
- providing electrically-conductive interconnect material (226) on the conductive pad (225).

10. The method as claimed in claim 9, the method further comprising:
- providing a first conductive part (230) and electrically coupling said part to the conductive pad (225) via the electrically-conductive interconnect material (226).

11. The method as claimed in claim 10, the method further comprising:
- providing a second conductive part and electrically coupling said part to another one of said at least two terminals (T1, T2).

12. The method as claimed in claim 11, the method further comprising:
- packaging said electronic device (200) to obtain a packaged semiconductor component.

13. The method as claimed in any one of claims 9 to 12, wherein the wall (229) that is provided comprises organic material.

14. The method as claimed in claim 13, wherein the wall (229) that is provided comprises material selected from a group comprising: polyimide, and epoxy polymer.

## Amended claims

### Amended claims in accordance with Rule 137(2) EPC.

**1.** An electronic device (200) for protection against transient voltages in high-power applications, the electronic device (200) comprising:
- a semiconductor substrate (220) comprising an active element (Dd) having at least two terminals (T1, T2);
- a conductive pad (225) provided on said substrate (220) and being electrically coupled to one of said terminals (T1, T2);
an insulating layer (228) provided around the periphery of the conductive pad (225);
- electrically-conductive interconnect material (226) provided on the conductive pad (225);
- a first conductive part (230) electrically coupled to the conductive pad (225) via the electrically-conductive interconnect material (226),
the electronic device further comprising:
a wall (229) being provided on top of the insulating layer (228) along the periphery of the conductive pad (225) for forming a lateral confinement of the interconnect material (226) on the conductive pad (225).

**2.** The electronic device (200) as claimed in claim 1, wherein the wall (229) comprises organic material.

**3.** The electronic device (200) as claimed in claim 2, wherein the wall (229) comprises material selected from a group comprising: polyimide, and epoxy polymer.

**4.** The electronic device (200) as claimed in any one of the preceding claims, wherein the active element comprises at least one of a diode (Dd), a transistor, and a thyristor.

**5.** The electronic device (200) as claimed in any one of the preceding claims, wherein the electrically-conductive interconnect material (226) comprises material selected from a group comprising: lead solder and lead-free interconnect materials such as high-conductive adhesives and sinter silver.

**6.** The electronic device (200) as claimed in any one of the preceding claims, further comprising a second conductive part electrically coupled to another one of said at least two terminals (T1, T2).

**7.** A packaged semiconductor component comprising the electronic device (200) as claimed in any one of the preceding claims.

**8.** A transient voltage suppression circuit comprising the electronic device (200 as claimed in any one of claims 1 to 6.

**9.** A method of manufacturing an electronic device (200) for protection against transient voltages in high-power applications, the method comprising:
- providing an intermediate device comprising:
i) a semiconductor substrate (220) comprising an active element (Dd) having at least two terminals (T1, T2), and
ii) a conductive pad (225) provided on said substrate (220) and being electrically coupled to one of said terminals (T1, T2);
an insulating layer (228) provided around the periphery of the conductive pad (225);
- providing a wall (229) on top of the insulating layer (228) along the periphery of the conductive pad (225) for forming a lateral confinement of interconnect material (226) to be applied on the conductive pad (225), and
- providing electrically-conductive interconnect material (226) on the conductive pad (225).

**10.** The method as claimed in claim 9, the method further comprising:
- providing a first conductive part (230) and electrically coupling said part to the conductive pad (225) via the electrically-conductive interconnect material (226).

**11.** The method as claimed in claim 10, the method further comprising:
- providing a second conductive part and electrically coupling said part to another one of said at least two terminals (T1, T2).

**12.** The method as claimed in claim 11, the method further comprising:
- packaging said electronic device (200) to obtain a packaged semiconductor component.

**13.** The method as claimed in any one of claims 9 to 12, wherein the wall (229) that is provided comprises organic material.

**14.** The method as claimed in claim 13, wherein the wall (229) that is provided comprises material selected from a group comprising: polyimide, and epoxy polymer.
